Europäisches Patentamt

European Patent Office

Office européen des brevets

(11) Veröffentlichungsnummer: **0 166 977**
**A2**

(12) # EUROPÄISCHE PATENTANMELDUNG

(21) Anmeldenummer: 85106772.8

(22) Anmeldetag: 01.06.85

(51) Int. Cl.⁴: **H 01 L 29/743**
H 01 L 29/52, H 01 L 29/08
H 01 L 29/10

(30) Priorität: 30.06.84 DE 3424222

(43) Veröffentlichungstag der Anmeldung:
08.01.86 Patentblatt 86/2

(84) Benannte Vertragsstaaten:
CH DE FR GB IT LI NL

(71) Anmelder: BROWN, BOVERI & CIE Aktiengesellschaft
Kallstadter Strasse 1
D-6800 Mannheim 31(DE)

(72) Erfinder: Irons, Robert Charles
Friedrichstrasse 16
D-6520 Worms(DE)

(72) Erfinder: Weimann, Klaus, Dipl.-Ing.
Wierdenstrasse 19
D-6840 Lampertheim(DE)

(74) Vertreter: Kempe, Wolfgang Dr. et al,
c/o Brown, Boveri & Cie AG Patentabteilung Postfach 351
D-6800 Mannheim 1(DE)

(54) Abschaltbarer Thyristor.

(57) Bedingt durch den Bahnwiderstand der p-Basisschicht eines abschaltbaren Thyristors wird der Hauptstrom zwischen Anode und Kathode während des Abschaltens in einer relativ langen Zeit in einer schmalen Zone unter dem Emitter geführt. Dieser bekannte Effekt begrenzt die Schaltleistung eines abschaltbaren Thyristors. Die Aufgabe, den Abschaltvorgang durch eine verbesserte Emitter/Kathode-Struktur zu beschleunigen, wird durch zwei schmale Emitterstreifen (2.11,2.12) je Teilkathode (7) gelöst, die am Ende der Teilkathode (7) verbunden sein können und die einen Abstand (A) haben, der aus Gründen der Wärmeabfuhr etwa der Dicke (D) der Schichten (3 bis 5) zwischen einer Emitterschicht (2) und einer Anode (11) entspricht. Eine Metallisierungsschicht (6) der Teilkathode (7) bedeckt dabei sowohl die Emitterstreifen (2. 11, 2. 12) als auch eine zwischen den Emitterstreifen (2. 11, 2. 12) auf der Oberfläche aufgebrachte Isolierschicht (14). Damit ergibt sich eine großflächige Teilkathode (7) mit geringem Längsspannungsabfall.

Fig 2

EP 0 166 977 A2

B R O W N , B O V E R I  &  C I E    AKTIENGESELLSCHAFT
Mannheim                                    28. Juni 1984
Mp.-Nr. 607/84                              ZPT/P3-Sf/Bt

## Abschaltbarer Thyristor

Die Erfindung betrifft einen abschaltbaren Thyristor
nach dem Oberbegriff des Anspruchs 1. Solche Thyristoren
können z.B. inselförmige Kathodenfinger aufweisen oder
die Kathodenstruktur kann z.B. kammartig mit einseitig
miteinander verbundenen Kathodenfingern ausgeführt sein.

Abschaltbare Thyristoren auch Gate-turn-off-(GTO)-Thyristoren genannt, sind aus zahlreichen Veröffentlichungen bekannt, beispielsweise aus den Drückschriften DE-AS
27 12 533, DE-PS 27 33 060 und DE-PS 29 06 721.

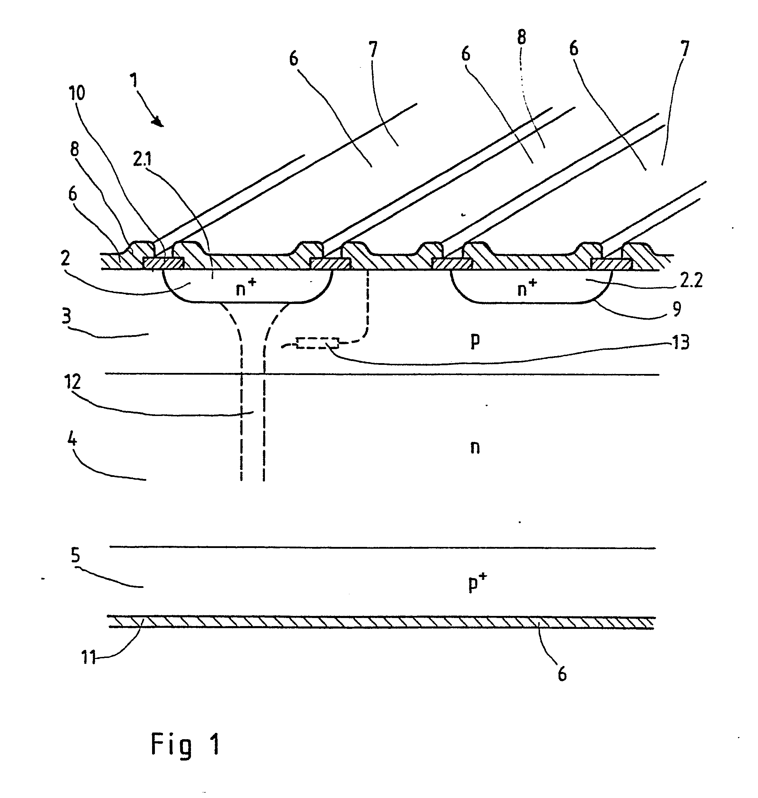

Ein Querschnitt eines Abschnitts eines abschaltbaren
Thyristors mit einem typischen Aufbau gemäß dem Stand
der Technik ist in Fig. 1 dargestellt. Der dargestellte
abschaltbare Thyristor 1 ist aus vier Siliziumschichten
2 bis 5 aufgebaut, wobei eine Emitterschicht 2 in mehrere Teilemitter 2.1, 2.2 aufgeteilt ist. Über den Teilemittern 2.1, 2.2 sind Metallisierungsschichten 6 zur
Bildung von Teilkathoden 7 aufgebracht. Jeweils links
und rechts von den fingerförmigen Teilkathoden 7 sind Gateflächen 8 als Metallisierungsschicht 6 auf einer p-Basisschicht 3 angeordnet. An den Stellen, an denen ein Übergang 9 zwischen Emitterschicht 2 und p-Basisschicht 3 an die Oberfläche tritt, ist eine Isolierschicht 10 vorgesehen. Die vierte Schicht 5 ist mit einer Metallisierungsschicht 6 als Anode 11 versehen. Nicht dargestellt ist eine erforderliche Verbindung der Teilkathoden 7 untereinander und mit einem äußeren Kathodenanschluß sowie die Verbindung der Gateflächen 8 untereinander und mit einem äußeren Gateanschluß.

Zur Abschaltung des Thyristors 1 wird eine negative Steuerspannung zwischen Gate 8 und Kathode 7 gelegt, wodurch ein Steuerstrom zwischen Gate 8 und Kathode 7 durch die p-Basisschicht 3 fließt. Die Elektronendichte in der p-Basisschicht 3 wird im Randbereich der Teilemitter 2.1, 2.2 abgesenkt und es fließt ein Löcherstrom von der Anode 11 durch die p-Basisschicht 3 zum Gate 8. Als Folge davon geht der Übergang 9 zwischen den Teilemittern 2.1, 2.2 und der p-Basisschicht 3 und auch der Übergang zwischen der p-Schicht 3 und der n-Schicht 4 von den Randbereichen der Teilemitter 2.1, 2.2 aus zur Mitte der Teilemitter 2.1, 2.2 hin in einer bestimmten Zeit in den Sperrzustand. Der Anoden-Kathoden-Strom zieht sich dabei auf eine schmale Zone 12 zusammen und bleibt erhalten bis der immer weiter fortschreitende Löcherentzug über den Gatestrom den Anodenstrom abklingen läßt. Die Verzögerung während der Abschaltung ist dabei abhängig von dem Bahnwiderstand 13 der p-Basisschicht 3.

Aus der vorstehenden Beschreibung der Vorgänge während des Abschaltens des Thyristors 1 ist ersichtlich, daß der durch die geometrische Anordnung bedingte Bahnwiderstand 13 der p-Basisschicht einen erheblichen Einfluß auf die Verzögerung während des Abschaltens hat. Aber auch weitere charakteristische Daten, wie z.B. die Abschaltverstärkung oder die maximale Durchbruchspannung oder die Strombelastbarkeit sind vom wirksamen Bahnwiderstand 13 abhängig. Die verzögerte Abschaltung bzw. ein hoher Strom in der schmalen Zone 12 über eine längere Dauer kann den Thyristor zerstören.

Der Erfindung liegt deshalb die Aufgabe zugrunde, einen abschaltbaren Thyristor mit einer verbesserten Emitter/Kathoden-Struktur anzugeben, die zu einer geringeren Abschaltverzögerung führt.

Diese Aufgabe wird durch einen abschaltbaren Thyristor nach dem Anspruch 1 gelöst.

Vorteile der damit vorgeschlagenen Lösung bestehen darin, daß der während des Abschaltvorganges für den zweiten Durchbruch maßgebliche Widerstand in Rückwärtsrichtung (revers bias second breakdown resistance) verbessert wird. Die Verzögerung während des Einschaltens ist geringer, die Spannungsanstiegsgeschwindigkeit ist erhöht und das Verhalten während des Abschaltens ist verbessert. Die vorgeschlagene Emitter/Kathoden-Struktur kann sowohl für Bauelemente mit Anodenkurzschlüssen als auch für solche ohne Anodenkurzschlüssen verwendet werden.

Weitere Vorteile und vorteilhafte Ausgestaltungen ergeben sich aus der nachstehenden Beschreibung eines Ausführungsbeispiels anhand der Zeichnung.

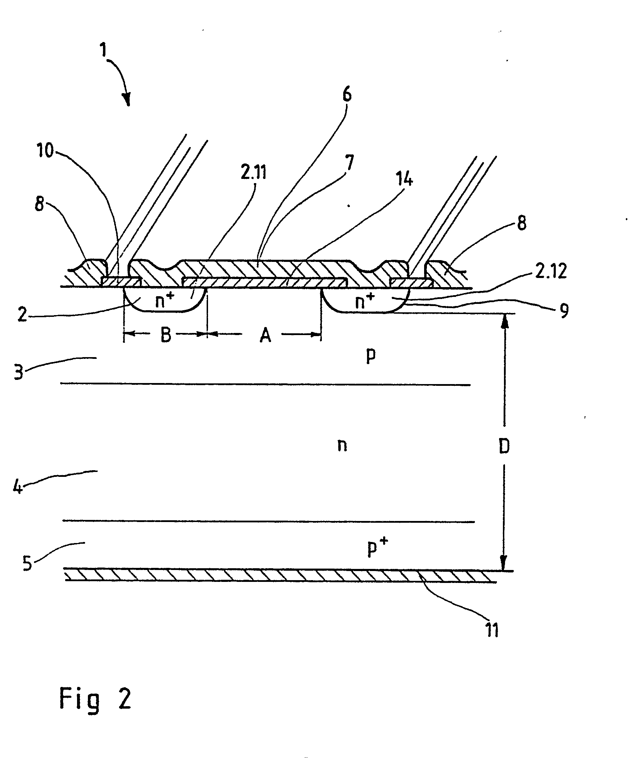

In Fig. 2 ist ein Ausschnitt aus einem erfindungsgemäßen abschaltbaren Thyristor 1 dargestellt. Der Thyristor 1 weist die gleichen vier Schichten 2 bis 5 mit einer Anode 11 auf der vierten Schicht 5 auf, wie der in Fig. 1 dargestellte und oben beschriebene Thyristor 1. Dargestellt ist eine Teilkathode 7, die links und rechts von Gateflächen 8 umgeben ist. Die Emitterschicht 2 unter der Teilkathode 7 ist aufgeteilt in zwei schmale Emitterstreifen 2.11, 2.12, die am Ende der Teilkathode 7 verbunden sein können. Die Breite B eines solchen Emitterstreifens 2.11, 2.12 beträgt zweckmäßig maximal 100 $\mu$m. Die beiden Emitterstreifen 2.11, 2.12 sollen einen Abstand haben, der etwa dem 0,2- bis 1,3-fachen der Dicke D der Schichten 3 bis 5 unter der Emitterschicht 2 entspricht. An den Stellen, an denen der Übergang 9 zwischen Emitter 2 und p-Basisschicht 3 an die Oberfläche tritt, ist eine Isolierschicht 10, 14 vorgesehen. Die Stelle zwischen den Emitterstreifen 2.11, 2.12, an denen die p-Basisschicht 3 an die Oberfläche tritt, ist durch eine breite Isolierschicht 14 abgedeckt. Bei den Isolierschichten 10, 14 handelt es sich um eine geeignete dielektrische Schicht, z.B. aus Siliziumoxid. Eine Metallisierungsschicht 6 der Teilkathoden 7 kontaktiert die zwei schmalen Emitterstreifen 2.11, 2.12 und überdeckt die breite Isolierschicht 14.

Mit den vorgeschlagenen schmalen Emitterstreifen 2.11, 2.12 wird erreicht, daß ein kleinerer Bahnwiderstand der p-Basisschicht 3 wirksam wird und damit ein beschleunigtes Schalten ohne Gefährdung des Thyristors 1 erfolgt. Es ist jedoch nicht zweckmäßig, die schmalen Emitterstreifen 2.11, 2.12 sehr eng nebeneinander zu legen, weil dann mit Erwärmungsproblemen zu rechnen ist. Wählt man dagegen den Abstand A zwischen zwei Emitterstreifen 2.11, 2.12 etwa so groß wie die Dicke D der Schichten 3 bis 5 zwischen der Emitterschicht 2 und der Anoden 11, so erreicht man eine günstige Wärmeabfuhr zu einem mit der Anode 11 verbundenen Kühler, wobei sich der Wärmestrom aufgrund einer Querleitung im Silizium auf die gesamte Fläche der Anode 11 verteilt.

Würde man die Teilkathoden 7 so schmal wie die Emitterstreifen 2.11, 2.12 ausführen, so wäre mit einem erheblichen Spannungsabfall längs einer fingerförmigen Teilkathode 7 zu rechnen. Deshalb wird durch Anwendung einer an sich bekannten overlay-Technik eine breite Teilkathode 7 geschaffen, indem sowohl die Emitterstreifen 2.11, 2.12 als auch die Isolierschicht 14 zwischen den Emitterstreifen 2.11, 2.12 von der Metallisierungsschicht 6 der Teilkathoden 7 überdeckt werden.

A n s p r ü c h e

1. Abschaltbarer Thyristor mit einer verteilten Kathodenstruktur, die fingerförmige Teilkathoden auf einer Emitterschicht aufweist, dadurch gekennzeichnet, daß

a)　die Emitterschicht (2) unter jeder Teilkathode (7) in zwei schmale parallele Emitterstreifen (2.11,2.12) aufgeteilt ist,.die in einem Abstand (A) zueinander angeordnet sind,

b)　eine zwischen den beiden Emitterstreifen (2.11,2.12) an die Oberfläche tretende p-Basisschicht (3) mit einer Isolierschicht (14) bedeckt ist und

c)　eine Metallisierungsschicht (6) zur Bildung der Teilkathode (7) die beiden Emitterstreifen (2.11,2.12) sowie die auf der dazwischenliegenden p-Basisschicht aufgebrachte Isolierschicht (14) bedeckt.

2. Abschaltbarer Thyristor nach Anspruch 1, dadurch gekennzeichnet, daß die Emitterstreifen (2.11,2.12) maximal 100 $\mu$m breit sind.

3. Abschaltbarer Thyristor nach Anspruch 1 oder 2, dadurch gekennzeichnet, daß der Abstand (A) zwischen zwei Emitterstreifen (2.11,2.12) dem 0,2- bis 1,3-fachen der Dicke (D) der unter der Emitterschicht (2) liegenden übrigen Schichten (2 bis 5) entspricht.

Fig 1

Fig 2